# EUROPEAN PATENT SPECIFICATION

(11) **EP 3 271 498 B1**
(45) Date of publication and mention of the grant of the patent: **05.12.2018**
(21) Application number: 16718516.4
(22) Date of filing: 21.03.2016
(51) Int. Cl.: C23C 16/44

(54) **METHOD FOR CLEANING DEPOSITION APPARATUS**
VERFAHREN ZUR REINIGUNG EINER ABLAGERUNGSVORRICHTUNG
PROCÉDÉ DE NETTOYAGE D'APPAREIL DE DÉPÔT

(30) Priority: 20.03.2015 NL 2014497
(43) Date of publication of application: 24.01.2018
(73) Proprietor: ASM International N.V., 1322 AP Almere (NL)
(72) Inventor: GRANNEMAN, Ernst Hendrik August, 1322 AP Almere (NL); COOLEN, Michiel Leonard Matthieu, 1322 AP Almere (NL); VAN VELZEN, Wilhelmus Gerardus, 1322 AP Almere (NL)
(74) Representative: V.O.
(86) International application number: PCT/NL2016/050195
(87) International publication number: WO 2016/153343

(56) References cited:
- US-A1- 2006 105 182
- US-A1- 2007 128 877
- US-B1- 6 699 375

## Description

### FIELD

The invention relates to the field of layer deposition, and more specifically to the field of removing deposition residues from deposition space components in a deposition apparatus.

### BACKGROUND

The deposition of layers on substrates in a deposition apparatus using CVD (chemical vapor deposition), PECVD (plasma enhanced chemical vapor deposition), ALD (atomic layer deposition), PVD (physical vapor deposition) and evaporation (D. opdampen) is known in the art. During a deposition treatment using a deposition apparatus, precursor material is introduced in a deposition space in which one or more substrates are present. During treatment at least part of the precursor material is deposited on the substrates, forming one or several layers thereon. Another part of the precursor material is deposited on deposition space components, such as the deposition space walls, forming deposition residue thereon. The deposition residue may have a negative effect on quality of the layers which are deposited on the substrates and may impair the operation of the deposition apparatus. In view thereof, deposition residue has to be removed from the deposition space walls after a plurality deposition treatments have been performed.

A first method which has been tested by applicant to remove deposition residue from anodized aluminium deposition space walls is by polishing the deposition space walls, for example, using red stone or other polishing tools, therewith removing the deposition residue. A second method which has been tested by applicant is a wet-etching treatment followed by a re-anodization step of the treated aluminium walls.

The disadvantage of both methods is that they are not selective. As a result, not only the deposition residue is removed, but the underlying deposition space walls may also be negatively affected. For example, an anodized layer on the deposition space walls may be removed with the etching treatment or the polishing treatment. Also, when using polishing, adjacent deposition space walls which do not have to be cleaned because no deposition residue is deposited on these adjacent deposition space walls may be damaged. For example, in the Levitrack™ of applicant, which is described in e.g. EP- 2 502 265 A2, the sidewalls of the deposition space may be damaged in the polishing process. Such damage makes the side walls rough, which in turn may cause some wafers, which are transported in the track-like deposition space, to stop upon colliding with a sidewall. As a result, the production of the deposition apparatus is interrupted, the deposition space chamber has to be opened, the collided wafer has to be removed and the production has to be restarted again. This is highly disadvantageous and leads to a significant loss in production capacity.

A disadvantage of the second method is the cost of the necessary re-anodization step of the treated aluminium walls.

US 2006/0105182 A1 discloses a process chamber for processing substrates such as semiconductor wafers and displays. Components of the process chamber such as the walls may be coated with a metal coating that comprises a material that is resistant to erosion from cleaning solutions that may be used to clean the component. Examples of materials that may be used for the underlying structure may be a metallic material, such as for example titanium, stainless steel, copper, tantalum and aluminum. Examples that are mentioned as a coating material are stainless steel, copper, nickel, tantalum and titanium. The surface of the coating may be treated with an electron beam to provide a desired texture of the metal coating surface, such as for example a desired roughness.

### SUMMARY

The invention is aimed at providing a cost effective method to remove deposition residue while substantially preventing damage to the deposition space components, such as the deposition space walls.

To that end, the invention provides a method for easily removing deposition residue from deposition space components of a deposition apparatus in which substrates are treated for applying at least one layer using one of CVD, PECVD, ALD, PVD and evaporation, wherein the method comprises:
- providing a deposition apparatus having a deposition space that is bounded by deposition space walls which are coated with a Ni or Cr-coating that has been applied with an electroplating or an electroless plating process;
- providing at least one precursor material that is introduced in the deposition space to deposit a layer on at least one substrate that has been introduced in the deposition space;
- performing at least one deposition treatment to apply the layer on the at least one substrate;
- cleaning the deposition space walls after a said deposition treatment with a selective wet-etching treatment in which the deposition space walls are treated with a liquid etching agent for removing a deposition residue formed on the deposition space walls during the deposition treatment;
wherein the composition of the deposition space wall coating is adapted to the composition of the deposition residue that is deposited on the deposition space walls during the deposition treatment and the liquid etching agent that is used during the selective wet etching treatment, such that the deposition residue is removed without affecting the deposition space walls, wherein the surface of the Ni- or Cr-coating is treated to provide a surface roughness (Ra) of at least 1,5 µm, preferably at least 2.5 µm and more preferably at least 3.2 µm, wherein the treatment of the surface to provide the surface roughness is a HVOF-coating treatment (high velocity oxygen fuel coating) or a HP-HVOF-coating treatment (high pressure high velocity oxygen fuel coating).

The method has the advantage that the deposition space walls remain unaffected when cleaning them with a selective wet-etching treatment. The selective wet-etching treatment does not have to be followed by a subsequent re-anodization step, as a result of which the cleaning treatment can effected in a cost-effective manner.

Additionally, the chance of damaging the deposition space walls is minimized, this in contrast with the above described cleaning method using polishing.

As a result, the life-time of the deposition space walls is increased compared to the prior art while, simultaneously, a cleaning method is obtained which is more cost effective and quicker than the cleaning methods which have been used previously.

The liquid etching agent is chosen to be effective in removing the respective deposition residue. Subsequently, the coating is chosen such that it is insensitive to the liquid etching agent used. Consequently, removal of deposition residue can be effected without affecting the deposition space walls.

The method according to the invention also obviates the need for (mechanical) polishing, for example using red stone, thus preventing damage to the deposition space walls.

The method can be used in a variety of deposition apparatus. The choice of the type of liquid etching agent should be tuned to the type of deposition residue to be removed so that an effective removal is possible. The choice of the type coating should be tuned the composition of the liquid etching agent used in the wet-etching treatment. In addition, the coating composition may vary depending on the material used for the deposition space walls and should be chosen in concordance therewith.

The selective wet-etching treatment may, for example, comprise submerging the deposition space walls in a wet-etching cleaning fluid. Alternatively, the selective wet-etching treatment may comprise manually cleaning the deposition space walls using a moist cloth which is moistened with the liquid etching agent.

The surface of the Ni- or Cr-coating has been treated to provide a surface roughness (Ra) of at least 1,5 µm, preferably at least 2.5 µm and more preferably at least 3.2 µm. The treatment of the surface to provide the surface roughness is a HVOF-coating treatment (high velocity oxygen fuel coating) or a HP-HVOF-coating treatment (high pressure high velocity oxygen fuel coating).

Such a HVOF- or HP-HVOF-coating treatment applies an additional coating having very good properties, such as an increased hardness and an inherent surface roughness within the claimed ranges.

An untreated Ni- or Cr-coating that has been applied with electroplating or electroless plating has a very smooth surface. Consequently, the deposition residue, for example Al₂O₃, may not stick very well to such a smooth surface. The consequence is that after a number of substrates that has been treated, the deposition residue may come off the deposition space wall, for example, when the temperature fluctuates. This has to be prevented. Consequently, the number of substrates that can be treated before the selective etch treatment has to be performed has to be kept within certain limits. However, by providing the surface treatment to the Ni- or Cr-coating, the upper limit of the number of substrates that can be treated increases with a factor 3 or 4 relative to a Ni- or Cr-coating which has not been treated to provide said surface roughness. This is, of course, very favorable for the production capacity of the deposition apparatus because the number of cleaning operations is less and, consequently, the standstill of the deposition apparatus is reduced dramatically.

In an embodiment, the deposition treatment may be ALD, which may, for example, be performed in a Levitrack™ as marketed by applicant.

In an embodiment, the deposition space walls are manufactured of aluminium.

Aluminium is a relatively cost effective material for manufacturing the deposition space walls of the deposition apparatus. Aluminium can be machined in a cost effective manner. Additionally, aluminium is light is beneficial for transport and placement of the deposition apparatus.

In an alternative embodiment, titanium may also be a feasible material for the deposition space walls.

In an embodiment, the precursor material comprises Al, wherein the deposition residue to be removed from the deposition space walls comprises Al₂O₃, and wherein the liquid etching agent comprises a solution of KOH, NaOH or tetramethylammonium hydroxide (TMAOH) in water.

A selective wet-etching treatment with a liquid etching agent comprising a solution of KOH, NaOH or TMAOH in water to remove deposition residue of AL₂O₃ from deposition space walls of ALD-apparatus is very effective. A Ni- or a Cr-coating protects the deposition space walls against damage by KOH, NaOH or TMAOH during the selective wet etching treatment. In fact, the Ni- or Cr-coating act as an etch stop.

In an embodiment, the concentration of KOH, NaOH or TMAOH in the liquid etching agent may be in the range of 20 to 600 gram/liter, and may preferably be in the range of 40 to 400 gram/liter. In an even more preferred embodiment, the concentration of the KOH, NaOH or TMAOH in the liquid etching agent may be approximately 250 gram/liter.

Generally, KOH-, NaOH and TMAOH-solutions with a wide range of concentrations may be used in the wet-etching treatment. The range provided in this embodiment has proven effective in the wet-etching treatment. In general, the time needed for a wet-etching treatment depends on the concentration, with higher concentrations leading to shorter treatment times. As such, lower concentrations are most useful for thinner deposition residues, whereas higher concentrations may be used for relatively thick deposition residues.

In an embodiment, the temperature of the liquid etching agent may be in the range of 15°C to 90°C, and may preferably be in the range of 20°C to 80°C. In an even more preferred embodiment, the temperature of the liquid etching agent during the selective wet etch treatment may be approximately 60°C.

Although the wet-etching treatment may be performed at various temperatures, a range of 20°C to 80°C has proven to be most preferable for performing the wet-etching treatment using a KOH-, NaOH- or TMAOH-solution. In general, a higher temperature provides a shorter treatment time. Lower temperatures are best used for removing thin layers of deposition residue.

A temperature of 65°C in conjunction with a concentration of 250 gram/liter has, for example, proven to be highly effective in removing Al₂O₃-films from deposition space walls made of aluminum.

Electroless plating has the advantage that the Ni or Cr coating will be formed everywhere, even in very small cavities. For example, the gas injection openings for an ALD-track like the Levitrack™ having a diameter in the sub-millimeter range will be internally coated with an electroless plating process.

The thickness of the Ni- or Cr-coating may be in the range of 5-40 µm and is preferably approximately 10-30 µm and even more preferably approximately 15 µm.

In an embodiment, the HVOF-coating treatment or HP-HVOF-coating treatment is executed with a powder including at least one of Chromium Carbide (Cr₃C₂), Tungsten carbide (chemical formula: WC) and Cobalt (Co).

This type of HVOF-coating is very hard and provides a very good protection of the Ni-coating and additionally provides the desired surface roughness. An example of a coating powder is Woka 7502 of Oerlikon Metco.

The invention also provides a deposition apparatus in which substrates are treated for applying at least one layer using one of CVD, PECVD, ALD, PVD and evaporation. According to the invention, the deposition apparatus includes deposition space walls that bound a deposition space, wherein the deposition space walls include a Ni- or Cr-coating that has been applied with an electroplating or an electroless plating process, and wherein the coating surface has been treated with a HVOF or HP-HVOF-coating treatment and has a surface roughness (Ra) of at least at least 1,5 µm, preferably at least 2.5 µm and more preferably at least 3.2 µm, wherein the coating applied with the HVOF or HP-HVOF-coating treatment includes at least one of Chromium Carbide (Cr₃C₂), Tungsten carbide (chemical formula: WC) and Cobalt (Co).

The deposition space walls of such a deposition apparatus may be cleaned very easily with the method according to the invention and thus provides all the advantages of the possibility to clean the deposition space walls by means of selective wet etching.

The embodiments may be combined or may be applied separate from each other.

### BRIEF DESCRIPTION OF FIGURES

Figure 1 shows an example of a Ni-coated aluminium deposition space wall before the selective wet etching treatment; and
Figure 2 shows the deposition space wall of figure 1 after the selective wet etching treatment has been performed.

### DETAILED DESCRIPTION

In this application similar or corresponding features are denoted by similar of corresponding reference signs. The description of the various embodiments is not limited to the examples shown in the figures and the reference numbers used in the detailed description and the claims are not intended to limit the description of the embodiments. The reference numbers are included to elucidate the embodiments by referring to the examples shown in the figures.

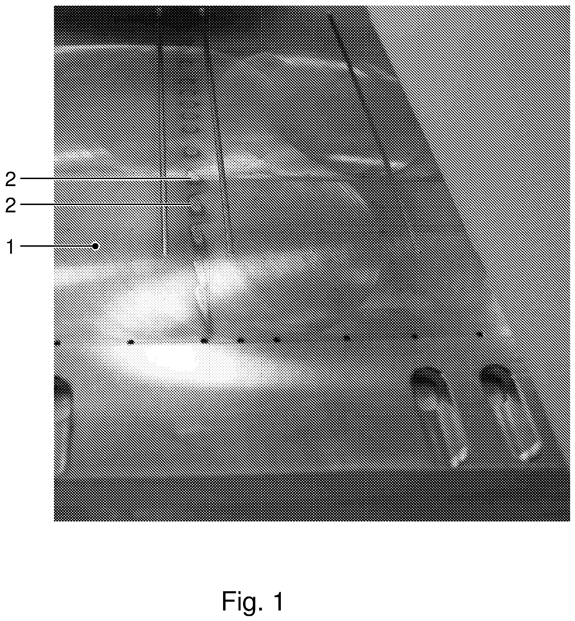

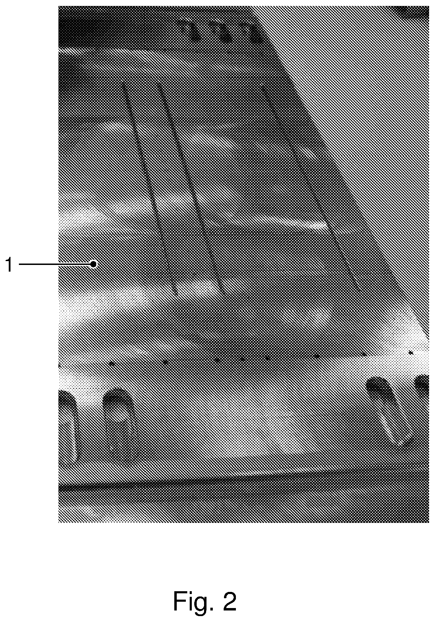

In a test Ni-coated aluminium deposition space walls were installed in an Levitrack™ system. The thickness of the Ni-coating was 20 µm. 9700 wafers were processed, resulting in some Al₂O₃ deposition on the Ni-plated process plates as shown in figure 1. The deposition residue 2 is clearly visible near precursor gas injection openings in the deposition space wall 1. Subsequently, the deposition space walls were subjected to the selective wet etching treatment by placing the walls in a container with 10% NaOH solution in water (a saturated solution that was diluted to 1/10 of the saturated concentration). The deposition space walls were left in the NaOH solution for ~ 10min. After ~2min most Al₂O₃ deposit residues were already largely dissolved. See for the result figure 2. Clearly visible is that the deposition residue 2 has been removed from the deposition space wall 1 without adversely affecting the deposition space wall surface. The advantages of the method according to the invention have been discussed in the summary, to which reference is made.

During another test a Ni-coated aluminium part was exposed to a solution of 10% NaOH in water. After 53.5 hours, the 199.8 gram part did not show any signs of corrosion and no weight loss could be measured (within an measurement accuracy of 0.1 gram). In the same bath, an uncoated aluminium part having the same dimensions suffered a weight loss of 0,076 in only 10 minutes. It is clear that the Ni-coating functions as an etch stop in a very effective manner.

The various embodiments may be applied in combination or may be applied independently from one another. Reference numbers used in the above detailed description are not intended to limit the description of the embodiments to the examples shown in the figures. The figures just represent examples and the embodiments may be embodied in other ways than the specific way shown in the examples of the drawings.

## Claims

1. A method for easily removing a deposition residue from deposition space components of a deposition apparatus in which substrates are treated for applying at least one layer using one of CVD, PECVD, ALD, PVD and evaporation, wherein the method comprises:
- providing a deposition apparatus having a deposition space that is bounded by deposition space walls which are coated with a Ni- or Cr-coating that has been applied with an electroplating or an electroless plating process;
- providing at least one precursor material that is introduced in the deposition space to deposit a layer on at least one substrate that has been introduced in the deposition space;
- performing at least one deposition treatment to apply the layer on the at least one substrate;
- cleaning the deposition space walls after a said deposition treatment with a selective wet-etching treatment in which the deposition space walls are treated with a liquid etching agent for removing a deposition residue formed on the deposition space walls during the deposition treatment;
wherein the composition of the deposition space wall coating is adapted to the composition of the deposition residue that is deposited on the deposition space walls during the deposition treatment and the liquid etching agent that is used during the selective wet etching treatment, such that the deposition residue is removed without affecting the deposition space walls, wherein the surface of the Ni- or Cr-coating is treated to provide a surface roughness (Ra) of at least 1,5 µm, preferably at least 2.5 µm and more preferably at least 3.2 µm, wherein the treatment of the surface to provide the surface roughness is a HVOF-coating treatment (high velocity oxygen fuel coating) or a HP-HVOF-coating treatment (high pressure high velocity oxygen fuel coating).

2. The method according to claim 1, wherein the deposition treatment is ALD.

3. The method according to claim 1 or 2, wherein the deposition space walls are manufactured of aluminium.

4. The method according to claim 1 or 2, wherein the deposition walls are manufactured of titanium.

5. The method according to any one of claims 1-4, wherein the precursor material comprises Al, wherein the deposition residue to be removed from the deposition space walls comprises Al2O3, and wherein the liquid etching agent comprises a solution of KOH, NaOH or tetramethylammonium hydroxide (TMAOH) in water.

6. The method according to claim 5, wherein the concentration of KOH, NaOH or TMAOH in the liquid etching agent is in the range of 20 to 600 gram/liter.

7. The method according to claim 6, wherein the concentration of KOH, NaOH or TMAOH in the liquid etching agent is in the range of 40 to 400 gram/liter.

8. The method according to claim 7, wherein the concentration of KOH, NaOH or TMAOH in the liquid etching agent is approximately 250 gram/liter.

9. The method according to any of claims 5-8, wherein during the selective wet etch treatment the temperature of the liquid etching agent is in the range of 15oC to 90oC.

10. The method according to claim 9, wherein the temperature of the liquid etching agent is in the range of 20oC to 80oC.

11. The method according to claim 10, wherein the temperature of the liquid etching agent is approximately 60°C

12. The method according to claim 1, wherein the HVOF-coating treatment or the HP-HVOF-coating treatment is executed with a powder including at least one of Chromium Carbide (Cr₃C₂), Tungsten carbide (chemical formula: WC) and Cobalt (Co).

13. A deposition apparatus in which substrates are treated for applying at least one layer using one of CVD, PECVD, ALD, PVD and evaporation, the deposition apparatus including deposition space walls that bound a deposition space, wherein the deposition space walls include a Ni- or Cr-coating that has been applied with an electroplating or an electroless plating process, and wherein the coating surface has been treated with a HVOF or HP-HVOF-coating treatment and has a surface roughness (Ra) of at least at least 1,5 µm, preferably at least 2.5 µm and more preferably at least 3.2 µm, wherein the coating applied with the HVOF or HP-HVOF-coating treatment includes at least one of Chromium Carbide (Cr₃C₂), Tungsten carbide (chemical formula: WC) and Cobalt (Co).

## Patentansprüche

1. Verfahren zur leichten Entfernung eines Ablagerungsrests von Ablagerungsraumkomponenten einer Ablagerungsvorrichtung, in der Substrate behandelt werden zum Anbringen von mindestens einer Lage unter Verwendung von CVD, PECVD, ALD, PVD und Verdampfung, wobei das Verfahren Folgendes umfasst:
- Bereitstellung einer Ablagerungsvorrichtung mit einem Ablagerungsraum, der begrenzt wird von Ablagerungsraumwänden, die beschichtet sind mit Ni- oder Cr-Beschichtung, die mit einem Elektroplattierungs- oder einem stromlosen Plattierungsverfahren angebracht wurde;
- Bereitstellung von mindestens einem Vorläufermaterial, das in den Ablagerungsraum eingeführt wird, um eine Schicht auf mindestens einem Substrat abzulagern, das in den Ablagerungsraum eingeführt wurde;
- Durchführung von mindestens einer Ablagerungsbehandlung, um die Lage auf dem mindestens einen Substrat anzubringen;
- Reinigung der Ablagerungsraumwände, wobei nach der Ablagerungsbehandlung mit einer selektiven Nassätzungsbehandlung, bei der die Ablagerungsraumwände mit einem Flüssigätzmittel behandelt werden, um einen Ablagerungsrest, gebildet auf den Ablagerungsraumwänden während der Ablagerungsbehandlung, zu entfernen;
wobei die Zusammensetzung der Ablagerungsraumwandbeschichtung so angepasst ist an die Zusammensetzung des Ablagerungsrests, der auf den Ablagerungsraumwänden während der Ablagerungsbehandlung abgelagert wird, und das Flüssigätzmittel, das während der selektiven Nassätzbehandlung verwendet wird, dass der Ablagerungsrest ohne Wirkung auf die Ablagerungsraumwände entfernt wird, wobei die Oberfläche der Ni- oder Cr-Beschichtung behandelt wird, um eine Oberflächenrauigkeit (Ra) von mindestens 1,5 µm, bevorzugt mindestens 2,5 µm und bevorzugter mindestens 3,2 µm bereitzustellen, wobei die Behandlung der Oberfläche zur Bereitstellung der Oberflächenrauigkeit eine HVOF-Beschichtungsbehandlung (high velocity oxygen fuel coating) oder eine HP-HVOF-Beschichtungsbehandlung (high pressure high velocity oxygen fuel coating) ist.

2. Verfahren nach Anspruch 1, wobei die Ablagerungsbehandlung ALD ist.

3. Verfahren nach Anspruch 1 oder 2, wobei die Ablagerungsraumwände aus Aluminium hergestellt sind.

4. Verfahren nach Anspruch 1 oder 2, wobei die Ablagerungswände aus Titan hergestellt sind.

5. Verfahren nach einem der Ansprüche 1-4, wobei das Vorläufermaterial Al umfasst, wobei der von den Ablagerungsraumwänden zu entfernende Ablagerungsrest Al203 umfasst und wobei das Flüssigätzmittel eine Lösung von KOH, NaOH oder Tetramethylammoniumhydroxid (TMAOH)) in Wasser umfasst.

6. Verfahren nach Anspruch 5, wobei die Konzentration von KOH, NaOH oder TMAOH in dem Flüssigätzmittel im Bereich von 20 zu 600 Gramm/Liter ist.

7. Verfahren nach Anspruch 6, wobei die Konzentration von KOH, NaOH oder TMAOH in dem Flüssigätzmittel im Bereich von 40 bis 400 Gramm/Liter ist.

8. Verfahren nach Anspruch 7, wobei die Konzentration von KOH, NaOH oder TMAOH in dem Flüssigätzmittel ungefähr 250 Gramm/Liter ist.

9. Verfahren nach einem der Ansprüche 5-8, wobei während der selektiven Nassätzbehandlung die Temperatur des Flüssigätzmittels im Bereich von 15°C bis 90°C ist.

10. Verfahren nach Anspruch 9, wobei die Temperatur des Flüssigätzmittels im Bereich von 20°C bis 80°C ist.

11. Verfahren nach Anspruch 10, wobei die Temperatur des Flüssigätzmittels ungefähr 60°C ist.

12. Verfahren nach Anspruch 1, wobei die HVOF-Beschichtungsbehandlung oder die HP-HVOF-Beschichtungsbehandlung ausgeführt wird mit einem Pulver, umfassend mindestens eines von Chromcarbid (Cr₃C₂), Wolframcarbid (chemische Formel WC) und Kobalt (Co).

13. Ablagerungsvorrichtung, in der Substrate behandelt werden zum Anbringen von mindestens einer Lage unter Verwendung von einem von CVD, PECVD, ALD, PVD und Verdampfung, die Ablagerungsvorrichtung umfassend Ablagerungsraumwände, die einen Ablagerungsraum begrenzen, wobei die Ablagerungsraumwände eine Ni- oder Cr-Beschichtung umfassend, die mit einem Elektroplattierungs- oder einem stromlosen Plattierungsverfahren angebracht wurde, und wobei die Beschichtungsoberfläche behandelt wurde mit einer HVOF- oder HP-HVOF-Beschichtungsbehandlung und eine Oberflächenrauigkeit (Ra) von mindestens 1,5 µm, bevorzugt mindestens 2,5 µm und bevorzugter mindestens 3,2 µm umfasst, wobei die mit der HVOF- oder HP-HVOF-Beschichtungsbehandlung angebrachte Beschichtung mindestens eines von Chromcarbid (Cr₃C₂), Wolframcarbid (chemische Formel: WC) und Kobalt (Co) umfasst.

## Revendications

1. Procédé pour éliminer aisément un résidu de dépôt sur des composants d'espace de dépôt d'un dispositif de dépôt dans lequel des substrats sont traités pour l'application d'au moins une couche utilisant l'un parmi les CVD, PECVD, ALD, PVD et une évaporation, lequel procédé comprend :
- la fourniture d'un dispositif de dépôt ayant un espace de dépôt qui est lié par des parois d'espace de dépôt qui sont revêtues d'un revêtement en Ni ou en Cr qui a été appliqué au moyen d'un procédé de placage électrolytique ou de placage autocatalytique ;
- la fourniture d'au moins un matériau précurseur qui est introduit dans l'espace de dépôt pour déposer une couche sur au moins un substrat qui a été introduit dans l'espace de dépôt ;
- la mise en oeuvre d'au moins un traitement de dépôt pour appliquer la couche sur l'au moins un substrat ;
- le nettoyage des parois d'espace de dépôt après ledit traitement de dépôt au moyen d'un traitement de gravure humide sélectif dans lequel les parois d'espace de dépôt sont traitées avec un agent de gravure liquide pour que soit éliminé un résidu de dépôt formé sur les parois d'espace de dépôt durant le traitement de dépôt ;
dans lequel la composition du revêtement de parois de dépôt est adaptée à la composition du résidu de dépôt qui est déposé sur les parois d'espace de dépôt durant le traitement de dépôt et à l'agent de gravure liquide qui est utilisé durant le traitement de gravure humide sélectif, de façon que le résidu de dépôt soit éliminé sans que les parois d'espace de dépôt soient affectées, dans lequel la surface du revêtement en Ni ou en Cr est traitée pour offrir une rugosité de surface (Ra) d'au moins 1,5 µm, de préférence d'au moins 2,5 µm et mieux encore d'au moins 3,2 µm, et dans lequel le traitement de la surface pour former la rugosité de surface est un traitement de revêtement HVOF (revêtement par flamme supersonique) ou un traitement de revêtement HP-HVOF (revêtement par flamme supersonique haute pression).

2. Procédé selon la revendication 1, dans lequel le traitement de dépôt est un ALD.

3. Procédé selon la revendication 1 ou 2, dans lequel les parois d'espace de dépôt sont fabriquées en aluminium.

4. Procédé selon la revendication 1 ou 2, dans lequel les parois d'espace de dépôt sont fabriquées en titane.

5. Procédé selon l'une quelconque des revendications 1 à 4, dans lequel le matériau précurseur comprend de l'Al, dans lequel le résidu de dépôt devant être éliminé des parois d'espace de dépôt comprend de l'Al₂O₃, et dans lequel l'agent de gravure liquide comprend une solution aqueuse de KOH, de NaOH ou d'hydroxyde de tétraméthylammonium (TMAOH).

6. Procédé selon la revendication 5, dans lequel la concentration de KOH, de NaOH ou de TMAOH dans l'agent de gravure liquide est située dans la plage allant de 20 à 600 grammes/litre.

7. Procédé selon la revendication 6, dans lequel la concentration de KOH, de NaOH ou de TMAOH dans l'agent de gravure liquide est située dans la plage allant de 40 à 400 grammes/litre.

8. Procédé selon la revendication 7, dans lequel la concentration de KOH, de NaOH ou de TMAOH dans l'agent de gravure liquide est d'environ 250 grammes/litre.

9. Procédé selon l'une quelconque des revendications 5 à 8, dans lequel, durant le traitement de gravure humide sélectif, la température de l'agent de gravure liquide est située dans la plage allant de 15°C à 90°C.

10. Procédé selon la revendication 9, dans lequel la température de l'agent de gravure liquide est située dans la plage allant de 20°C à 80°C.

11. Procédé selon la revendication 10, dans lequel la température de l'agent de gravure liquide est d'environ 60°C.

12. Procédé selon la revendication 1, dans lequel le traitement de revêtement HVOF ou le traitement de revêtement HP-HVOF est exécuté avec une poudre comprenant au moins l'un parmi le carbure de chrome (Cr₃C₂), le carbure de tungstène (formule chimique : WC) et le cobalt (Co).

13. Dispositif de dépôt dans lequel des substrats sont traités pour l'application d'au moins une couche utilisant l'un parmi les CVD, PECVD, ALD, PVD et une évaporation, le dispositif de dépôt comprenant des parois d'espace de dépôt qui lient un espace de dépôt, dans lequel les parois d'espace de dépôt comprennent un revêtement en Ni ou en Cr qui a été appliqué au moyen d'un procédé de placage électrolytique ou de placage autocatalytique, et dans lequel le revêtement de surface a été traité par un traitement de revêtement HVOF ou HP-HVOF et a une rugosité de surface (Ra) d'au moins 1,5 µm, de préférence d'au moins 2,5 µm et mieux encore d'au moins 3,2 µm, et dans lequel le revêtement appliqué par le traitement de revêtement HVOF ou HP-HVOF comprend au moins l'un parmi le carbure de chrome (Cr₃C₂), le carbure de tungstène (formule chimique : WC) et le cobalt (Co).
